# EUROPÄISCHE PATENTSCHRIFT

(11) **EP 1 771 934 B1**
(45) Veröffentlichungstag und Bekanntmachung des Hinweises auf die Patenterteilung: **24.11.2010**
(21) Anmeldenummer: 05768655.2
(22) Anmeldetag: 25.07.2005
(51) Int. Cl.: H02M 3/155

(54) **ANSTEUERUNG VON LEISTUNGSSCHALTERN**
CONTROL OF POWER BREAKERS
COMMANDE DE DISJONCTEURS

(30) Priorität: 30.07.2004 DE 102004036958
(43) Veröffentlichungstag der Anmeldung: 11.04.2007
(60) Teilanmeldung: 10173357.4
(73) Patentinhaber: Tridonic GmbH & Co KG, 6851 Dornbirn (AT)
(72) Erfinder: ZUDRELL-KOCH, Stefan, 6845 Hohenems (AT); KNOEDGEN, Horst, 80997 München (DE)
(74) Vertreter: Rupp, Christian
(86) Internationale Anmeldenummer: PCT/EP2005/008077
(87) Internationale Veröffentlichungsnummer: WO 2006/013035

(56) Entgegenhaltungen:
- DE-A1- 10 120 789
- DE-A1- 10 163 032
- DE-C1- 10 137 752
- DE-C1- 19 841 757
- US-A- 4 504 779
- US-A- 4 567 378
- US-A1- 2001 048 294
- US-A1- 2003 218 388
- US-A1- 2004 090 804
- US-A1- 2004 140 833
- US-B1- 6 194 884

## Beschreibung

Die vorliegende Erfindung bezieht sich allgemein auf das Gebiet der Ansteuerung von Leistungsschaltern, wie sie beispielsweise in einer PFC (Power Factor Control)-Schaltung Verwendung finden können.

Aus dem Stand der Technik ist es bereits bekannt, daß ein bestimmter zeitlicher Verlauf, insbesondere im Bereich der Flanken, des Schaltverhaltens eines Leistungsschalters vorteilhaft hinsichtlich einer Verringerung der durch den Schaltvorgang erzeugten elektromagnetischen Störungen (EMI, Electromagnetic Interference) ist.

Die vorliegende Erfindung geht von dieser Erkenntnis aus und hat sich zur Aufgabe gemacht, eine Technik bereitzustellen, mittels der in flexibler Weise auch unterschiedlichen Leistungsschaltern ein gewünschtes Schaltungsverhalten auferlegt werden kann.

Aus der DE 101 63 032 A1 ist ein Betriebsverfahren für ein Betriebsgerät für Leuchtelemente mit geregelter Ansteuerung eines Leistungsschalters einer PFC-Schaltung des Betriebsgeräts bekannt.

Aus der US 2001/048294 A1 ist eine Schaltung bekannt, bei der durch Ansteuerung eines Leistungsschalters an dessen Ausgang ein gewünschter Strom-/Spannungsverlauf erzielt werden kann.

Diese Aufgabe wird erfindungsgemäß durch die Merkmale der unabhängigen Ansprüche gelöst. Die abhängige Ansprüche bilden den zentralen Gedanken der Erfindung in besonders vorteilhafter Weise weiter.

Gemäß einem ersten Aspekt der Erfindung ist ein Verfahren zur geregelten Ansteuerung eines Leistungsschalters einer PFC-Schaltung eines Betriebsgeräts für Leuchtelemente vorgesehen. Dabei wird zuerst ein Sollverhalten des Stroms und/oder der Spannung durch den bzw. an den Leistungsschalter zumindest für einen zeitlichen Abschnitt eines Schaltvorgangs vorgegeben.

Das tatsächliche Verhalten (Istverhalten) dieses Parameters wird gemessen und zur Bildung einer geschlossenen Regelschleife zurückgeführt. Schließlich wird das gemessene Istverhalten mit dem Sollverhalten verglichen und die Ansteuerung des Leistungsschalters derart bewirkt, daß das Istverhalten im wesentlichen dem Sollverhalten folgt.

Das Sollverhalten kann insbesondere den Flankenverlauf des Schaltvorgangs, beispielsweise anhand wenigstens zweier Stützpunkte vorgeben.

Werte, die das Sollverhalten wiedergeben, können beispielsweise als diskrete Werte in einem Speicher abgelegt sein. Alternativ oder zusätzlich kann das Sollverhalten auch mittels einer analogen Schaltung, beispielsweise mittels eines Rechteck-Oszillators mit begrenzter Flankensteilheit, vorgegeben werden.

Die vorliegende Erfindung bezieht sich gemäß einem weiteren Aspekt auch auf ein Verfahren zur Kalibrierung des Schaltverhaltens eines Leistungsschalters. Dabei wird der Strom und/oder die Spannung durch den bzw. an dem Leistungsschalter zumindest für einen zeitlichen Abschnitt eines Schaltvorgangs gemessen. Daraufhin wird die Ansteuerung des Leistungsschalters dahingehend abgeglichen, daß zur Erzielung einer geringen elektromagnetischen Störung während des Schaltverhaltens das tatsächliche Schaltverhalten im wesentlichen einem vorgegebenen Sollverhalten entspricht, wobei das Sollverhalten hinsichtlich der elektromagnetischen Interferenz (EMI) optimiert ist.

Ein derartiges Kalibrierverfahren wird hierbei für einen Leistungsschalter in einer PFC-Schaltung verwendet.

Die Erfindung bezieht sich auch auf ein Computersoftware-Programmprodukt, das ein derartiges Verfahren implementiert, wenn es auf einer Recheneinrichtung läuft, beispielsweise in einem ASIC programmiert ist.

Schließlich bezieht sich die vorliegende Erfindung auch auf eine Leistungsschalter-Regelschaltung. Diese Regelschaltung weist Mittel zur Vorgabe eines Sollverhaltens des Stroms und/der Spannung durch einen bzw. an einem Leistungsschalter zumindest für einen zeitlichen Abschnitt eines Schaltvorgangs auf. Weiterhin sind Mittel zur Messung des Istverhaltens sowie zur Rückführung des Meßergebnisses vorgesehen. Schließlich ist eine Regeleinrichtung vorgesehen, die die Ansteuerung des Leistungsschalters derart ausführt, daß das Istverhalten im wesentlichen dem Sollverhalten entspricht.

Diese Regeleinrichtung kann beispielsweise ein ASIC und/oder eine diskrete Schaltung sein.

Schließlich bezieht sich die vorliegende Erfindung auch auf ein System zur Kalibrierung des Schaltverhaltens eines Leistungsschalters, auf ein Betriebsgerät für Leuchtelemente, auf ein elektronisches Vorschaltgerät (EVG) für Gasentladungslampen sowie auf eine PFC-Schaltung, die jeweils eine derartige Regelschaltung aufweisen.

Weitere Eigenschaften, Vorteile und Merkmale der vorliegenden Erfindung sollen nunmehr bezugnehmend auf die Figuren der beigefügten Zeichnungen näher erläutert werden.
- Fig. 1: zeigt dabei eine schematische Übersicht über eine erfindungsgemäße analoge Regelschaltung,
- Fig. 2: zeigt eine schematische Übersicht über eine erfindungsgemäße digitale Regelschaltung,
- Fig. 3: zeigt eine erfindungsgemäße Kalibrierung einer Ansteuerschaltung, und
- Fig. 4: zeigt die Anwendung einer erfindungsgemäßen Regelschaltung im Rahmen einer PFC (Power Factor Correction) - Schaltung.

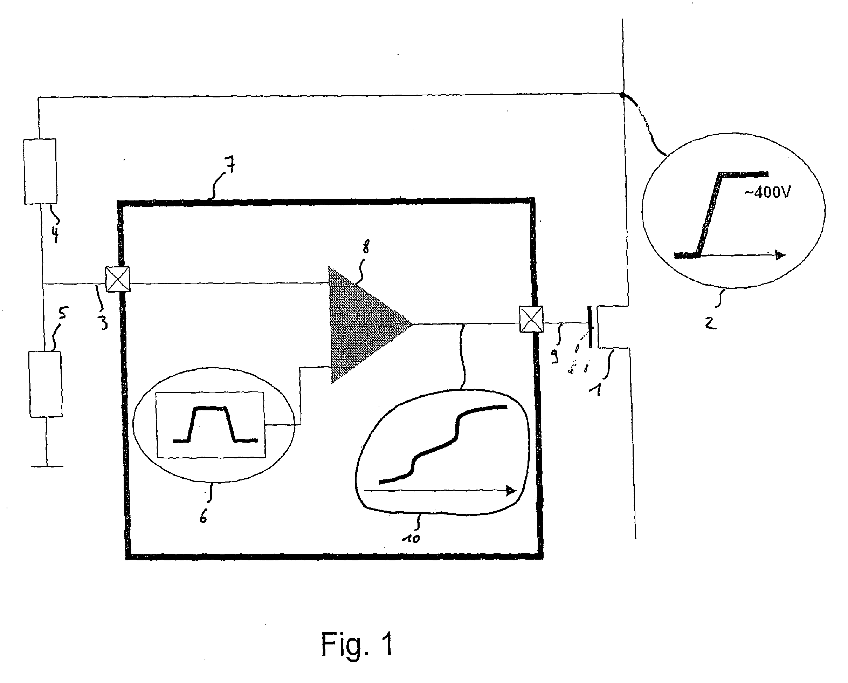

In Fig. 1 ist ein Leistungsschalter als FET-Transistor 1 ausgebildet. Dem Steuereingang (hier: Gate) 31 dieses Leistungsschalters 1 wird ein Ansteuersignal 9 von einer Regeleinrichtung zugeführt, die im vorliegenden Ausführungsbeispiel eine integrierte Schaltung (ASIC) 7 sein kann, beispielsweise aber auch als diskrete oder hybride Schaltung aufgebaut sein kann.

Mittels eines Spannungsteilers aufweisend Widerstände 4, 5 wird ein Parameter des Schaltverhaltens des Leistungsschalters 1 zumindest während eines Teils der Zeitdauer von Schaltvorgängen, insbesondere während der Flanken, erfaßt. Dieser Parameter kann beispielsweise der Strom *I* durch den Leistungsschalter 1 und/oder die Spannung *U* an dem Leistungsschalter 1 sein.

Wie bereits erwähnt kann die Messung/Regelung auf bestimmte zeitliche Abschnitte wie bspw. die dynamischen Bereiche (Flanken) begrenzt sein, aber auch kontinuierlich das Schaltverhalten anhand wenigstens eines Parameters überwachen, so dass auch die statischen Bereiche überwacht und geregelt werden.

Das Bezugszeichen 2 zeigt schematisch ein in dieser Weise gemessenes Istverhalten des Schaltverhaltens im Bereich einer ansteigenden Flanke, d.h. eines Einschaltvorgangs des Leistungsschalters 1. Im vorliegenden Beispiel wird die an dem Schalter 1 anliegende Spannung U gemessen und geregelt. Wie aus Fig. 1 ersichtlich ist das Istverhalten, das durch die erfindungsgemäße Regelschaltung optimiert ist, derart geregelt, daß die Flanke einen vorbestimmten Verlauf und insbesondere eine vorbestimmte endliche Flankensteilheit aufweist.

Es ist anzumerken, daß durch die erfindungsgemäße Regelschaltung auch andere Flankenverläufe und insbesondere nichtlinear verlaufende Flankenverläufe bei entsprechender Vorgabe (siehe weiter unten im Zusammenhang der Erläuterung des Bezugszeichens 6) erzielt werden können.

Der gemessene Parameter wird einem Eingang 3 der Regeleinrichtung (ASIC) 7 zugeführt. Die Regeleinrichtung 7 weist einen Komparator 8 auf, der das gemessene, an dem Eingang 3 zugeführte Istsignal mit einem extern oder im vorliegenden Beispiel intern vorgegebenen Sollverhalten 6 vergleicht und abhängig von diesem Vergleich zur Implementierung eines Regel-Algorithmus ein Korrektursignal als Ansteuersignal 9 an den Steuereingang des Leistungsschalters 1 abgibt.

Das Sollverhalten 6 kann in unterschiedlicher Weise, beispielsweise unter Zuhilfenahme eines Rechteck-Oszillators mit begrenzter Flankensteilheit, implementiert werden.

Die in Fig. 1 dargestellte Regelschaltung weist eine analoge Schaltung zur Implementierung des Sollverhaltens 6 auf. Dabei kann im Falle einer derartigen analogen Sollwertvorgabe ein kontinuierliches Sollverhalten auferlegt werden.

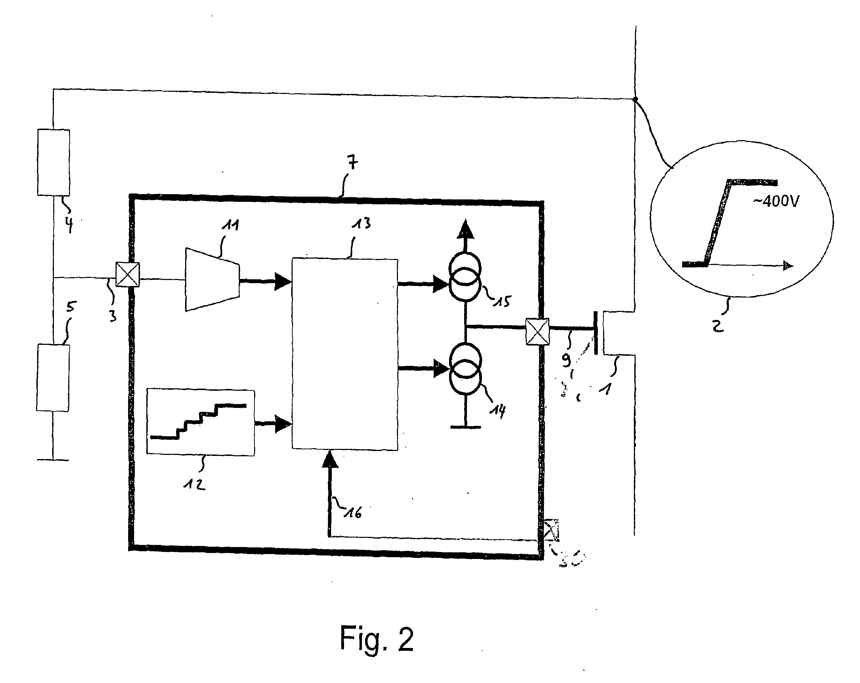

In Fig. 2 ist eine schematische Übersicht über eine digitale Ausführungsform der erfindungsgemäßen Regelschaltung gezeigt.

Wie in der analogen Ausführungsform der Fig. 1 wird ein Leistungsschalter 1 von einem Ansteuersignal 9 gespeist. Das Istverhalten eines Parameters des Leistungsschalters 9 - wie beispielsweise des Stroms und/oder der Spannung durch den bzw. an dem Leistungsschalter 9 - wird wiederum von einer Regeleinrichtung 7 mit Hilfe eines Spannungsteilers 4, 5 erfasst.

Die Funktion der Regeleinrichtung 7 besteht in einem Vergleich des gemessenen Istverhaltens mit einem vorgegebenen Sollverhalten 12 und in einer dementsprechenden Ansteuerung 9 des Leistungsschalters 9.

Der Vergleich der Ist- und Sollverhalten und die zeitliche Reaktion darauf wird von einer Logikschaltung 13 durchgeführt, die u.a. die Funktion eines digitalen Komparators enthält. Ein Analog-Digital-Wandler 11 zur Digitalisierung des erfassten Eingangs-Parameters 3 liefert der Logikschaltung 13 das entsprechende digitale Istverhalten. Die das Sollverhalten wiedergebenden diskreten Digitalwerte werden aus einem Speicher 12 einem weiteren Eingang der Logikschaltung 13 zugeführt.

Ein weiterer Eingang der Logikschaltung 13 dient als Steuereingang 16. Über den Steuereingang 16 lässt sich bspw. das dynamische Regelverhalten mittels Einstellung der zeitlichen Reaktion der Logikschaltung auf Regelabweichungen einstellen.

Eine Bereitstellung des Sollverhaltens mittels digitaler Werte in einem Speicher gemäss dem Ausführungsbeispiel von Figur 2 hat den Vorteil, daß im wesentlichen beliebige, auch nichtlineare Verläufe insbesondere im Bereich der Flanken für das Schaltverhalten vorgegeben werden können.

Minimal sind dabei für eine Flanke zwei diskrete Stützwerte in dem Speicher 12 abgelegt, wodurch bereits eine geradlinig verlaufende Flanke vorgegeben werden kann. Für komplexere Flankenverläufe oder aber auch zur Präzisierung derartiger geradliniger Flanken kann selbstverständlich die Anzahl der Stützwerte, die das Sollverhalten wiedergeben, beliebig erhöht werden.

Nachdem die Logikschaltung 13 der Regeleinrichtung 7 die Ist- und Sollverhalten in der Art eines Fehlerverstärkers ("Error Amplifier") verglichen hat, steuert er programmierbar Stromquellen 14, 15 derart an, dass der Leistungsschalter 1 mit dem gewünschten Ansteuersignal 9 betrieben wird, also das Istverhalten im wesentlichen dem Sollverhalten folgt.

Die gerade beschriebenen analogen und digitalen Ausführungsbeispiele betreffen also eine Ausführungsform, bei der eine geschlossene Regelschleife während des Betriebs des Leistungsschalters 1 die Ansteuerung korrekturmäßig nachregelt, um das Sollverhalten zu erreichen.

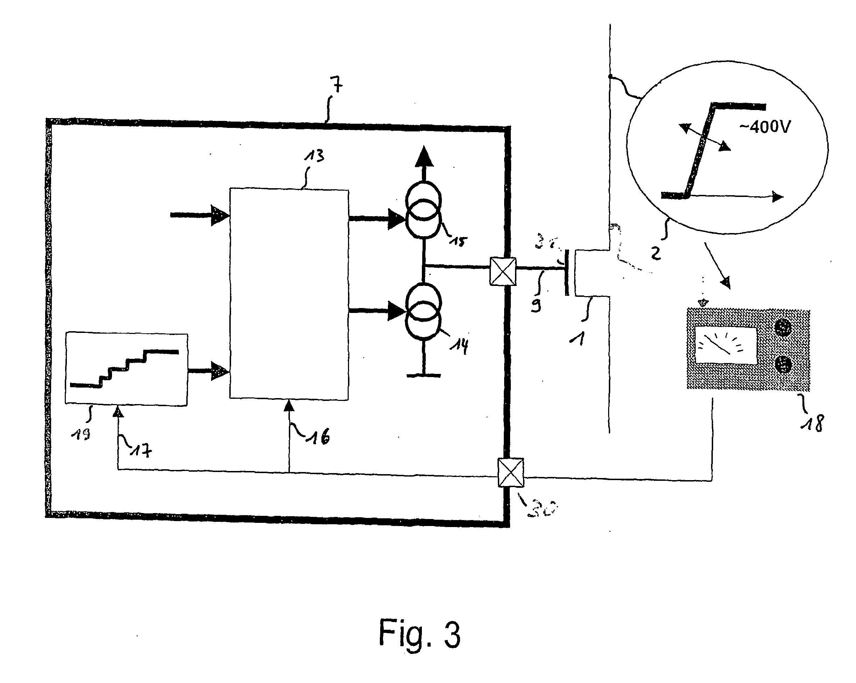

Indessen betrifft die vorliegende Erfindung auch die einmalige Kalibrierung einer Ansteuerschaltung, bei der ein bestehendes Schaltverhalten 2 des Leistungsschalters 1 einmalig mittels eines speziellen Messgeräts 18 erfasst wird und dann eine einmalige, bspw. werksseitige Kalibrierung der Ansteuerschaltung 7 durchgeführt wird. Dies ist schematisch in Fig. 3 dargestellt. Bei dieser Ausführungsform ist ein externer oder hier interner, programmierbarer Kalibrierspeicher 19 vorgesehen (bei den zuvor genannten Ausführungsbeispielen ist der Speicher 6 bzw. 12 nicht notwendigermassen programmierbar).

Beispielsweise bei der Fertigung wird also die Ansteuerschaltung 7 einmalig kalibriert, so daß dann im eigentlichen Betrieb des Leistungsschalters 1 eine Messung und eine geschlossene Regelschleife zur Verwertung des Meßergebnisses des Leistungsschalters-Parameters nicht erforderlich sind.

Die Messung und Kalibrierung kann indessen jederzeit, bspw. in fest vorgegebenen Abständen oder bei Auferlegung einer neuen Funktionalität erneut durchgeführt werden.

Die Kalibrierung kann dabei wie dargestellt durch interne Abspeicherung 19 von Kalibrierdaten erfolgen, die den zeitlichen Verlauf der Ansteuerung beeinflussen. Vorstellbar ist aber auch eine externe Kalibrierung über einen Trimmeingang etc. (nicht dargestellt).

Zur Kalibrierung wird also über ein Messgerät 18 das Schaltverhalten erfasst. Über einen Programmiereingang 30 der integrierten Schaltung 7 können dann die Werte des Kalibrierspeichers 19 (Programmierzugriff 17) und/oder das dynamische Verhalten ("Control Pattern")der Logikschaltung 13 eingestellt werden.

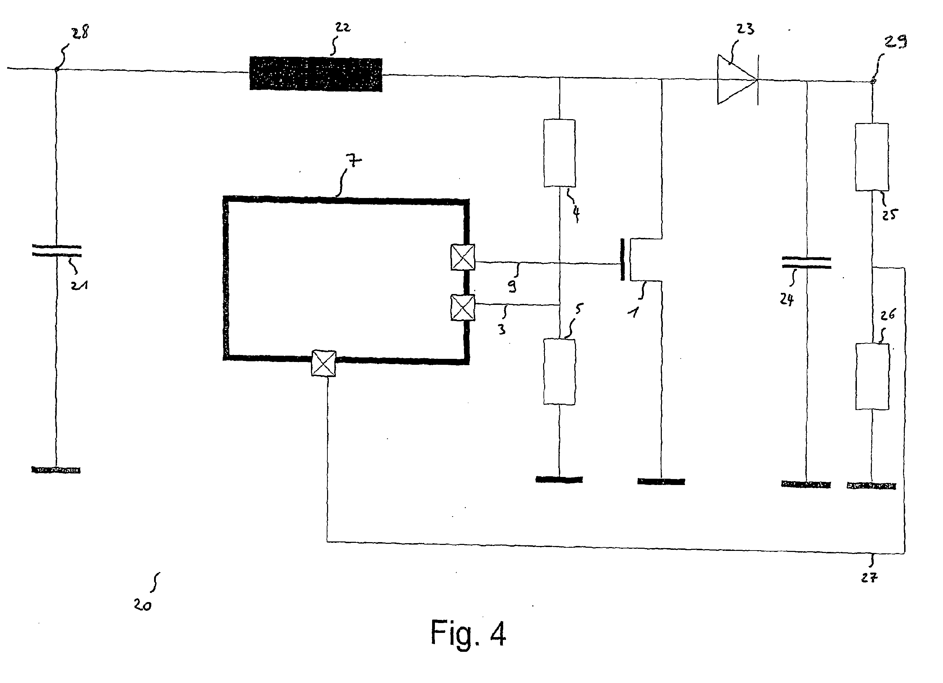

Fig. 4 zeigt schließlich, wie die erfindungsgemäße Technik bei einer PFC (Power Factor Correction)-Schaltung angewendet werden kann. In dem Ausführungsbeispiel von Fig. 4 wird beispielsweise die Spannung über dem Leistungsschalter 1 überwacht, um durch gezielte Ansteuerung des Schalters eine Verringerung durch hochfrequente Störungen zu erzielen.

Wie aus dem Stand der Technik grundsätzlich bekannt, wird die Eingangs-Spannung 28 einer PFC-Schaltung 20 von einem Glättungskondensator 21 gesiebt und einer Induktivität 22, i.e. einer Spule, zugeführt. Die Induktivität 22 wird mittels des Leistungsschalters 1 wahlweise geladen bzw. entladen. Die PFC-Schaltung 20 weißt außerdem eine in Serie zu der Induktivität 22 geschaltete Diode 23 auf.

Wenn der Leistungsschalter 1 eingeschaltet ist, ist die Induktivität 22 gegen Masse kurzgeschlossen und die Diode 23 gesperrt. Die Induktivität 22 lädt sich dann auf, so dass Energie in der Induktivität 22 gespeichert wird.

Wenn der Leistungsschalter 1 hingegen ausgeschaltet ist, ist die Diode 23 leitend. Die Induktivität 22 entlädt sich dann über die Diode 23 in den Ausgangs-Kondensator 24. Die Energie wird dadurch an den Ausgangs-Kondensator 24 übertragen.

Der Spannungsteiler 4, 5 dient dazu, das Istverhalten des Stroms und/oder der Spannung durch den bzw. an dem Leistungsschalter 1 zu ermitteln 3. Mittels eines weiteren Spannungsteilers 25, 26 kann die Ausgangs-Spannung 29 gemessen werden 27.

Die im ASIC 7 vorgesehene Treiberschaltung für die Ansteuerung des Leistungsschalters 1 ist in den Figuren nicht dargestellt.

Durch die geschlossene Regelschleife bzw. die Kalibrierung können Toleranzen des Leistungsschalters 1 kompensiert werden, so daß stets im wesentlichen das gewünschte Sollverhalten erzielt werden kann. Somit kann beispielsweise dasselbe ASIC für verschiedene Leistungsstufen von Gasentladungslampen verwendet werden, die unterschiedlich dimensionierte Schalter benötigen. Insgesamt ergibt sich also ein geregeltes Schaltverhalten.

Bei der Kalibrierung kann sozusagen eine "Universal-Treiberschaltung" vorgesehen sein, die abhängig von der zuvor ausgeführten Messung des entsprechenden Parameters des Leistungsschalters auf den speziell verwendeten Leistungsschalter hin spezifiziert wird.

### Liste der in den Figuren benutzten Bezugszeichen:

| | |
|---|---|
| 1 | Leistungsschalter, bspw. FET-Transistor |
| 2 | gemessenes Istverhalten des Stroms und/oder der Spannung durch den bzw. an dem Leistungsschalter |
| 3 | Eingang der Regeleinrichtung |
| 4 | Widerstand eines Spannungsteilers |
| 5 | Widerstand eines Spannungsteilers |
| 6 | analoges vorgegebenes Sollverhalten |
| 7 | Regeleinrichtung: integrierte Schaltung (ASIC), bzw. diskrete Schaltung |
| 8 | Komparator |
| 9 | Ansteuersignal des Leistungsschalters |
| 10 | Darstellung des Ansteuersignals |
| 11 | Analog-Digital-Wandler |
| 12 | digitales vorgegebenes Sollverhalten, bzw. digitaler Speicher |
| 13 | digitale Logikschaltung |
| 14 | Stromquelle |
| 15 | Stromquelle |
| 16 | Steuereingang |
| 17 | externe Abspeicherung von Kalibrierdaten |
| 18 | Messgerät |
| 19 | Kalibrierspeicher |
| 20 | PFC-Schaltung |
| 21 | Glättungskondensator |
| 22 | Induktivität |
| 23 | Diode |
| 24 | Ausgangs-Kondensator |
| 25 | Widerstand eines Spannungsteilers |
| 26 | Widerstand eines Spannungsteilers |
| 27 | gemessene Ausgangs-Spannung |
| 28 | Eingangs-Spannung |
| 29 | Ausgangs-Spannung |

## Patentansprüche

1. Betriebsverfahren für ein Betriebsgerät für Leuchtelemente mit geregelter Ansteuerung eines Leistungsschalters (1) einer PFC-Schaltung des Betriebsgeräts,
**gekennzeichnet durch** die folgenden Schritte:
- Vorgabe eines einstellbaren Sollverhaltens des Stroms und/oder der Spannung **durch** den bzw. an dem Leistungsschalter
(1) zumindest für einen zeitlichen Abschnitt eines Schaltvorgangs,
- Messung (4, 5) und Rückführung (3) des Ist-Verhaltens des Stroms und/oder der Spannung **durch** den bzw. an dem Leistungsschalter (1) während eines Schaltvorgangs, und
- Regelung (9) der Ansteuerung des Leistungsschalters (1) derart, dass das Ist-Verhalten im wesentlichen dem Sollverhalten entspricht.

2. Verfahren nach Anspruch 1,
bei dem die Vorgabe des einstellbaren Sollverhaltens mittels eines programmierbaren Speichers (6, 12) erfolgt.

3. Verfahren nach Anspruch 1 oder 2,
**dadurch gekennzeichnet,**
**dass** das Sollverhalten anhand wenigstens zweier Stützpunkte vorgegeben wird.

4. Verfahren nach einem der vorhergehenden Ansprüche,
**dadurch gekennzeichnet,**
**dass** das Sollverhalten den Flankenverlauf des Schaltvorgangs vorgibt.

5. Verfahren nach einem der vorhergehenden
Ansprüche,
**dadurch gekennzeichnet,**
**dass** Werte, die das Sollverhalten wiedergeben, in einem Speicher (6) abgelegt sind und/oder mittels einer analogen Schaltung bereitgestellt werden.

6. Verfahren nach einem der vorhergehenden
Ansprüche,
**dadurch gekennzeichnet,**
**dass** die Dynamik des Regelverhaltens einstellbar ist.

7. Verfahren nach Anspruch 1,
**dadurch gekennzeichnet,**
**dass** das Sollverhalten programmiert wird.

8. Betriebsgerät für Leuchtelemente,
aufweisend eine PFC-Schaltung mit einem Leistungsschalter (1) und eine Leistungsschalter-Regelschaltung, die
aufweist:
- einen Speicher (6, 12) zur Vorgabe eines einstellbaren Sollverhaltens
des Stroms und/oder der Spannung durch einen bzw. an einem
Leistungsschalter (1) zumindest für einen zeitlichen Abschnitt eines Schaltvorgangs,
- Mittel zur Messung (4, 5) und Rückführung (3) des Ist-Verhaltens des Stroms und/oder der Spannung durch den bzw. an dem Leistungsschalter (1) während eines Schaltvorgangs, und
- Mittel zur Regelung der Ansteuerung (9) des Leistungsschalters derart, dass das Ist-Verhalten im Wesentlichen dem Sollverhalten entspricht.

9. Betriebsgerät nach Anspruch 8,
bei dem der Speicher programmierbar ist.

10. Betriebsgerät nach Anspruch 8 oder 9,
**dadurch gekennzeichnet,**
**dass** die Dynamik des Regelungsverhaltens der Regelungsmittel einstellbar (30) ist.

11. Betriebsgerät nach einem der Ansprüche 8 bis 10, **dadurch gekennzeichnet,**
**dass** die Mittel zur Regelung ein ASIC aufweisen.

12. Betriebsgerät nach einem der Ansprüche 8 bis 10, **dadurch gekennzeichnet,**
**dass** die Mittel zur Regelung eine diskrete Schaltung aufweisen.

13. Betriebsgerät nach einem der Ansprüche 8 bis 12,
**dadurch gekennzeichnet,**
**dass** Werte, die das Sollverhalten wiedergeben, in einem Speicher abgelegt sind.

14. Betriebsgerät nach einem der Ansprüche 8 bis 13,
**dadurch gekennzeichnet,**
**dass** die Sollwertvorgabe mittels einer analogen Schaltung erfolgt.

15. Betriebsgerät nach
Anspruch 14,
**dadurch gekennzeichnet,**
**dass** die analoge Schaltung einen Rechteck-Oszillator mit begrenzter Flankensteilheit aufweist.

16. Elektronisches Vorschaltgerät für
Gasentladungslampen, aufweisend ein Betriebsgerät nach einem der Ansprüche 8 bis 15.

17. Betriebsgerät für Leuchtelemente nach Anspruch 8, bei dem die PFC-Schaltung eine Induktivität (22) aufweist, die über einen Leistungsschalter (1) selektiv geladen und entladen wird, wobei bei ausgeschaltetem Leistungsschalter (1) die in der Induktivität (22) gespeicherte Energie über eine Diode (23) entladen wird.

18. Leistungsfaktorkorrektur(PFC)-Schaltung,
aufweisend eine Induktivität (22), die über einen Leistungsschalter (1) selektiv geladen und entladen wird, wobei bei ausgeschaltetem Leistungsschalter (1) die in der Induktivität (22) gespeicherte Energie über eine Diode (23) entladen wird,
weiterhin aufweisend eine Regelschaltung für den Leistungsschalter (1), die
aufweist:
- Mittel (6) zur Vorgabe eines einstellbaren Sollverhaltens des Stroms und/oder der Spannung durch einen bzw. an einem Leistungsschalter (1) zumindest für einen zeitlichen Abschnitt eines Schaltvorgangs,
- Mittel zur Messung (4, 5) und Rückführung (3) des Ist-Verhaltens des Stroms und/oder der Spannung durch den bzw. an dem Leistungsschalter (1) während eines Schaltvorgangs, und
- Mittel zur Regelung der Ansteuerung (9) des Leistungsschalters derart, dass das Ist-Verhalten im wesentlichen dem Sollverhalten entspricht.

## Claims

1. Operating method for an operating appliance for light elements with regulated control of a circuit breaker (1) of a PFC circuit of the operating appliance **characterized by** the following steps:
- presetting of a variable nominal behaviour of the current and/or of the voltage respectively through and on the circuit breaker (1) at least for a time period of a switching process,
- measurement (4, 5) and feedback (3) of the actual behaviour of the current and/or the voltage through and respectively on the circuit breaker (1) during a switching process, and
- regulation (9) of the control of the circuit breaker (1) such that the actual behaviour corresponds essentially to the nominal behaviour.

2. Method according to Claim 1,
wherein the adjustable nominal behaviour is preset by means of a programmable memory (6, 12).

3. Method according to Claim 1 or 2,
**characterized in that**
the nominal behaviour is predetermined on the basis of at least two support points.

4. Method according to one of the preceding claims, **characterized in that**
the nominal behaviour presets the flank profile of the switching process.

5. Method according to one of the preceding claims, **characterized in that**
the values which reflect the nominal behaviour are stored in the memory (6) and/or are provided by means of an analogue circuit.

6. Method according to one of the preceding claims, **characterized in that**
the dynamics of the control behaviour are adjustable.

7. Method according to Claim 1,
**characterized in that**
the nominal behaviour is programmed.

8. Operating appliance for light elements,
having a PFC circuit with a circuit breaker (1) and a circuit breaker control circuit, which has,
- a memory (6, 12) for presetting an adjustable nominal behaviour of the current and/or of the voltage through and respectively on a circuit breaker (1) at least for a time period of a switching process,
- means for measurement (4, 5) and feedback (3) of the actual behaviour of the current and/or of the voltage through and respectively on the circuit breaker (1) during a switching process, and
- means for regulating the control (9) of the circuit breaker such that the actual behaviour corresponds essentially to the nominal behaviour.

9. Operating appliance according to Claim 8,
wherein the memory is programmable.

10. Operating appliance according to Claim 8 or 9, **characterized in that**
the dynamics of the control behaviour of the control means are adjustable (30).

11. Operating appliance according to one of Claims 8 to 10,
**characterized in that**
the means for regulation have an ASIC.

12. Operating appliance according to one of Claims 8 to 10,
**characterized in that**
the means for regulation have a discrete circuit.

13. Operating appliance according to one of Claims 8 to 12,
**characterized in that**
values which reflect the nominal behaviour are stored in a memory.

14. Operating appliance according to one of Claims 8 to 13,
**characterized in that**
the nominal values are preset by means of an analogue circuit.

15. Operating appliance according to Claim 14, **characterized in that**
the analogue circuit has a square-wave oscillator with a limited flank gradient.

16. Electronic ballast for gas discharge lamps,
having an operating appliance according to one of Claims 8 to 15.

17. Operating appliance for light elements according to Claim 8, in which the PFC circuit has an inductance (22) which is selectively charged and discharged via a circuit breaker (1), wherein, when the circuit breaker (1) is switched off, the energy which is stored in the inductance (22) is discharged via a diode (23).

18. Power factor correction (PFC) circuit, having an inductance (22) which is selectively charged and discharged via a circuit breaker (1), wherein, when the circuit breaker (1) is switched off, the energy which is stored in the inductance (22) is discharged by a diode (23),
furthermore having a control circuit for the circuit breaker (1), which has:
- means (6) for presetting an adjustable nominal behaviour of the current and/or of the voltage through and respectively on the circuit breaker (1) at least for a time period of a switching process,
- means for measurement (4, 5) and feedback (3) of the actual behaviour of the current and/or of the voltage through and respectively on the circuit breaker (1) during a switching process, and
- means for regulating the control (9) of the circuit breaker such that the actual behaviour corresponds essentially to the nominal behaviour.

## Revendications

1. Procédé pour le fonctionnement d'un appareil d'alimentation pour éléments d'éclairage avec une commande régulée d'un disjoncteur (1) d'un circuit de correction de facteur de puissance de l'appareil d'alimentation,
**caractérisé par** les étapes suivantes :
- fixation d'un comportement de consigne réglable du courant à travers le disjoncteur et/ou de la tension aux bornes de celui-ci pendant au moins une section temporelle d'un processus de commutation,
- mesure (4, 5) et transmission (3) du comportent effectif du courant à travers le disjoncteur (1) et/ou de la tension aux bornes de celui-ci pendant un processus de commutation, et
- régulation (9) de la commande du disjoncteur (1) de sorte que le comportent effectif correspond essentiellement au comportement de consigne.

2. Procédé selon la revendication 1,
pour lequel la fixation du comportement de consigne réglable est effectuée au moyen d'une mémoire programmable (6, 12).

3. Procédé selon la revendication 1 ou 2,
**caractérisé en ce que**
le comportement de consigne est fixé à l'aide d'au moins deux points de soutien.

4. Procédé selon l'une des revendications précédentes,
**caractérisé en ce que**
le comportement de consigne fixe l'évolution de la pente du processus de commutation.

5. Procédé selon l'une des revendications précédentes,
**caractérisé en ce que**
des valeurs qui représentent le comportement de consigne sont enregistrées dans une mémoire (6) et/ou sont mises à disposition au moyen d'un circuit analogique.

6. Procédé selon l'une des revendications précédentes,
**caractérisé en ce que**
la dynamique du comportement en régulation peut être ajustée.

7. Procédé selon la revendication 1,
**caractérisé en ce que**
le comportement de consigne est programmé.

8. Appareil d'alimentation pour moyens d'éclairage,
présentant un circuit de correction de facteur de puissance avec un disjoncteur (1) et un circuit de régulation de disjoncteur, qui présente :
- une mémoire (6, 12) pour la fixation d'un comportement de consigne réglable du courant à travers un disjoncteur et/ou de la tension aux bornes de celui-ci pendant au moins une section temporelle d'un processus de commutation,
- des moyens de mesure (4, 5) et transmission (3) du comportent effectif du courant à travers le disjoncteur (1) et/ou de la tension aux bornes de celui-ci pendant un processus de commutation, et
- des moyens de régulation de la commande (9) du disjoncteur de sorte que le comportent effectif correspond essentiellement au comportement de consigne.

9. Appareil d'alimentation selon la revendication 8,
pour lequel la mémoire est programmable.

10. Appareil d'alimentation selon la revendication 8 ou 9,
**caractérisé en ce que**
la dynamique du comportement en régulation des moyens de régulation est réglable (30).

11. Appareil d'alimentation selon l'une des revendications 8 à 10,
**caractérisé en ce que**
les moyens de régulation présentent un ASIC.

12. Appareil d'alimentation selon l'une des revendications 8 à 10,
**caractérisé en ce que**
les moyens de régulation présentent un circuit discret.

13. Appareil d'alimentation selon l'une des revendications 8 à 12,
**caractérisé en ce que**
des valeurs qui représentent le comportement de consigne sont enregistrées dans une mémoire.

14. Appareil d'alimentation selon l'une des revendications 8 à 13,
**caractérisé en ce que**
la fixation de valeur de consigne a lieu au moyen d'un circuit analogique.

15. Appareil d'alimentation selon la revendication 14,
**caractérisé en ce que**
le circuit analogique présente un oscillateur rectangulaire ou crénau avec une pente limitée.

16. Ballast électronique pour lampes à décharge de gaz,
présentant un appareil d'alimentation selon l'une des revendications 8 à 15.

17. Appareil d'alimentation pour éléments d'éclairage selon la revendication 8,
pour lequel le circuit de correction de facteur de puissance présente une bobine (22), qui est chargée et déchargée sélectivement via un disjoncteur (1),
l'énergie emmagasinée dans la bobine (22) étant déchargée via une diode (23) en cas de disjoncteur (1) éteint.

18. Circuit de correction de facteur de puissance,
présentant une bobine (22), qui est chargée et déchargée sélectivement via un disjoncteur (1),
l'énergie emmagasinée dans la bobine (22) étant déchargée via une diode (23) en cas de disjoncteur (1) éteint,
présentant en outre un circuit de régulation pour le disjoncteur (1), qui présente :
- des moyens (6) pour la fixation d'un comportement de consigne réglable du courant à travers un disjoncteur (1) et/ou de la tension aux bornes de celui-ci pendant au moins une section temporelle d'un processus de commutation,
- des moyens de mesure (4, 5) et transmission (3) du comportent effectif du courant à travers le disjoncteur (1) et/ou de la tension aux bornes de celui-ci pendant un processus de commutation, et
- des moyens de régulation de la commande (9) du disjoncteur de sorte que le comportent effectif correspond essentiellement au comportement de consigne.
